**Europäisches Patentamt**

**European Patent Office**

**Office européen des brevets**

(11) Publication number: **0 032 510**
**B1**

## EUROPEAN PATENT SPECIFICATION

(45) Date of publication of patent specification: **21.01.87**

(21) Application number: **80901614.0**

(22) Date of filing: **23.07.80**

(86) International application number:
**PCT/US80/00917**

(87) International publication number:
**WO 81/00326 05.02.81 Gazette 81/04**

(51) Int. Cl.⁴: **H 01 L 21/22, H 01 L 21/265**

(54) **SILICON ON SAPPHIRE LASER PROCESS.**

(30) Priority: **24.07.79 US 60081**

(43) Date of publication of application:
**29.07.81 Bulletin 81/30**

(45) Publication of the grant of the patent:
**21.01.87 Bulletin 87/04**

(84) Designated Contracting States:
**DE FR GB NL**

(56) References cited:
**US-A-3 585 088**
**US-A-4 070 211**
**US-A-4 151 008**
**US-A-4 160 984**
**US-A-4 187 126**
**US-A-4 198 246**
**US-A-4 203 781**
**US-A-4 214 918**
**US-A-4 229 232**
**US-A-4 249 960**

(73) Proprietor: **Hughes Aircraft Company**
**7200 Hughes Terrace P.O. Box 45066**
**Los Angeles California 90045-0066 (US)**

(72) Inventor: **YARON, Giora**
**19857 Beekman Place**
**Cupertino, CA 95014 (US)**
Inventor: **HARARI, Eliyahou**
**2320 Friars Lane**
**Los Altos, CA 94022 (US)**
Inventor: **WANG, Samuel T.**
**24052 Saleno Lane**
**Mission Viejo, CA 92675 (US)**
Inventor: **HESS, LaVerne D.**
**1462 Dorset Avenue**
**Thousand Oaks, CA 91360 (US)**

(74) Representative: **Milhench, Howard Leslie et al**
**A.A. Thornton & Co. Northumberland House**
**303/306 High Holborn**
**London, WC1V 7LE (GB)**

Courier Press, Leamington Spa, England.

(56) References cited:

RCA REVIEW, vol. 40, no. 3, September 1979, PRINCETON, C.P. WU et al.: "Laser annealing to round the edges of silicon structures", pages 339-344

PROCEEDINGS OF THE 6TH. CONFERENCE ON SOLID STATE DEVICES TOKYO 1974, SUPPLEMENT TO THE JOURNAL OF THE JAPAN SOCIETY OF APPLIED PHYSICS, vol. 44, 1975, TOKYO (JP), H. TANGO et al.: "N-channel Si-gate MOS devices on sapphire substrates", pages 225-231

INTERNATIONAL ELECTRON DEVICES MEETING 1978, IEEE NEW YORK (US), A.C. IPRI: "Sub-micron polysilicon gate CMOS/SOS technology", pages 46-49

IEEE TRANSACTIONS ON ELECTRON DEVICES, vol. ED-27, no. 3, March 1980, NEW YORK (US), G. YARON et al.: "Laser annealed silicon on sapphire", pages 573-578

Applied physics letters, 32 (8) 15 April 1980, Celler et al., "Spatially controlled crystal growth of ion-implanted silicon by laser irradiation", p. 464-466

International electron devices meeting, 5 December 1979, Washington D.C., Lam et al., "Device and circuit fabrication and physical characterization of pulsed-laser-annealed polysilicon on SiO2 and Si3N4", p. 213-215

## Description

This invention is related to a method for treating a surface region of semiconductor material, in particular a metal oxide semiconductor device formed in silicon on sapphire on which the edge of a silicon island is improved by application of an energy beam.

It is well known in the art that the speed of metal oxide semiconductor (MOS) devices may be increased by forming each individual MOS field effect transistor (FET) in a silicon island on a sapphire substrate which is isolated from other MOSFET's. Fabrication of such silicon on sapphire (SOS) devices is accomplished by growing epitaxial silicon on a sapphire substrate and then etching the silicon to form individual islands on which individual MOSFETs may be fabricated. A significant problem in the art of silicon on sapphire (SOS) is that aluminum conductors interconnecting between individual MOSFETs on the sapphire substrate must cover a nearly vertical step formed at the edge of each silicon island. A reduction in the thickness of the deposited aluminum conductor and cracks in the aluminum may occur in the vicinity of a vertical step. Such cracks and reduction in the thickness of the deposited aluminum increases the likelihood of discontinuities in the aluminum conductor which cause device failure.

A related problem which is peculiar to SOS devices is that growth of a silicon dioxide layer over the silicon island usually is accompanied by a region of reduced oxide thickness resulting in a "V"-shaped groove at the lower corner of each silicon island edge. If a polycrystalline silicon conductive layer is deposited or grown thereover, the amount of insulation between the overlying polysilicon conductor and the silicon island is greatly reduced at the V-shaped groove, thereby increasing the likelihood of breakdown conduction through the insulating oxide film between the polysilicon conductor and the silicon islands.

The present invention provides a method for treating a surface region of semiconductor material comprising a silicon island of predefined extent having edges which is characterised by irradiating the surface of the silicon island with a radiation beam of a chosen energy per unit area sufficient to cause the silicon material in the vicinity of the edges to reflow, whereby the step geometry at the edges of the silicon island are smoothed and rounded to provide improved step coverage for layers subsequently deposited thereover. The exposure to a radiation beam in accordance with the invention causes the material in the silicon island edge to reflow, resulting in a reduction in the slope of the silicon island edge. The face of the silicon island edge becomes smoother during this reflow process, so that the roughness of the face is eliminated to provide a smooth and gradually sloping step.

A significant result of the use of this process is that oxide film overlying the silicon islands has a uniform thickness even in the vicinity of the bottom edge corner of the silicon island. The uniform thickness of the oxide film provides uniform insulation between an overlying polysilicon conductor and the silicon island, thereby eliminating the problem of breakdown conduction at the bottom edge corner of the silicon island.

In a further aspect, the present invention provides in a metal oxide semiconductor silicon-on-sapphire device having a plurality of silicon islands, a method for improving metal step coverage by a metal layer and for preventing breakdown conduction between an insulated conductive layer and the silicon islands, comprising forming a plurality of silicon islands on a sapphire substrate to define an island edge surrounding each of said silicon islands and the method being characterised by exposing said silicon islands to a beam of energy of sufficient magnitude to cause the silicon material in the vicinity of said island edge to reflow so as to reduce the slope and smooth the surface of said edges.

It should be noted that, if high temperature furnace processing were used in an attempt to avoid the foregoing problems, high leakage currents at the silicon-sapphire interface between the source and the drain of the MOS transistor would occur. Such problems are avoided in this invention by applying a laser beam of sufficiently short wavelength and pulse duration so that the radiation is absorbed within a thin surface layer and over a time period shorter than the characteristic longitudinal thermal transport time of the silicon island. In the preferred embodiment of the invention, the silicon islands are exposed to radiation from an excimer laser emitting radiation having a wavelength of 2490 Å, a pulse duration of 25 nanoseconds, a beam size in the range of 0.1 to 0.2 $cm^2$ and an energy density in the range of 0.5 to 1.0 joules/$cm^2$. Alternatively, a pulsed ion beam or electron beam source may be used in a similar fashion. Furthermore, a continuous laser, ion or electron beam source, may be used in which the beam is scanned across the surface of the device.

Following application of the laser beam, the roughness on the edge face of each island has been found to disappear, and the step defined by each island edge has been found to be more gradual. Subsequently, a first oxide layer is grown, followed by deposition and definition of polysilicon conductors, which are then implanted simultaneously with implantation of source and drain regions. Thereafter, a top oxide layer is deposited, contact openings are etched through the oxide layers followed by deposition and definition of aluminum conductors. The resulting step coverage of overlying aluminum conductors was found to be improved, the thickness of the aluminum conductors being uniform throughout the device, thereby solving the problem of discontinuities normally encountered in step coverage by the aluminum layer.

## Brief Description of the Drawings

The invention is best understood by reference to the accompanying drawings of which:

FIG. 1 is a simplified cross-sectional view of a silicon-on-sapphire (SOS) island of the prior art over which a MOSFET is to be fabricated;

FIG. 2 is a partial top view of the SOS device of FIG. 1 after deposition of oxide layers and conductors;

FIG. 3 is a cross-sectional view of the silicon island of FIG. 2 taken along lines 3—3 of FIG. 2 and clearly showing the reduced insulation between a polysilicon conductor and the silicon island at the bottom edge corner of the island;

FIG. 4 is a cross-sectional view of the silicon island of FIG. 2 taken along lines 4—4 of FIG. 2 clearly showing the reduced thickness and poor step coverage of an aluminum conductor;

FIG. 5 is a simplified cross-sectional view of an SOS island similar to that of FIG. 1, illustrating the application of an energy beam according to the method of the present invention;

FIG. 6 is a partial top view of the SOS device of FIG. 3 after application of the energy beam and after deposition of overlying oxide and metal layers;

FIG. 7 is a simplified cross-sectional view of the silicon island of FIG. 6 taken along lines 7—7 of FIG. 6 clearly showing the improved insulation between the polysilicon conductor and the silicon island at its bottom edge corner;

FIG. 8 is a simplified cross-sectional view of the silicon island of FIG. 6 taken along lines 8—8 of FIG. 6 clearly showing the improved step coverage of the aluminum conductor.

## Detailed Description of the Invention

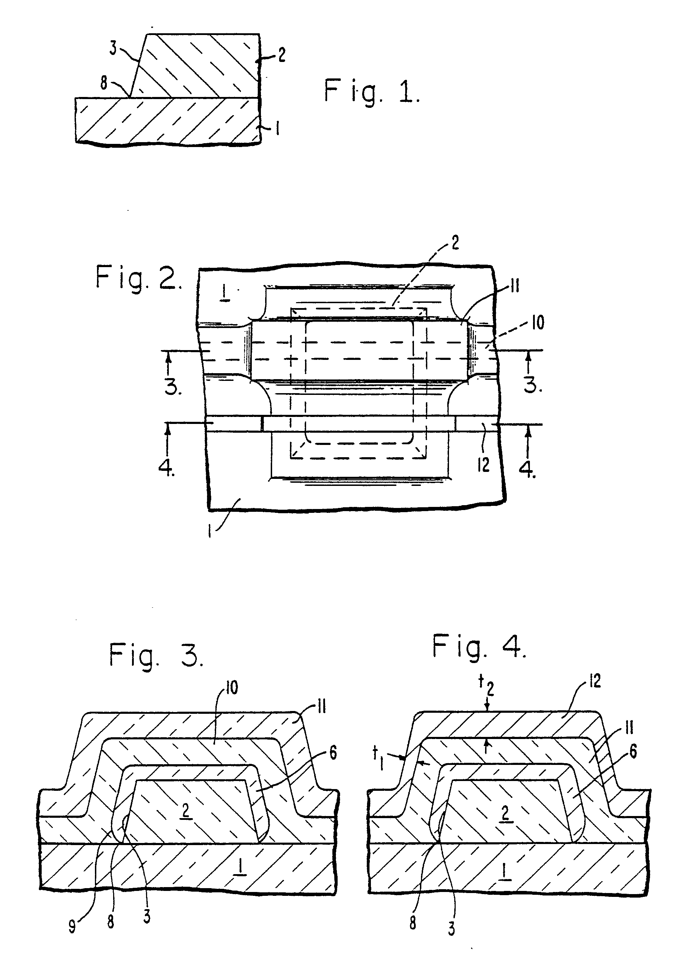

FIG. 1 is a simplified cross sectional view of a silicon on sapphire (SOS) island including a sapphire substrate 1 and a silicon island 2 photolithographically defined by an etching process to form an island edge 3. The island edge 3 has a steep slope created during definition of the silicon island 2.

Referring to FIG. 3, a first oxide layer 6 is preferably grown over the top surface of the silicon island 2 and the thickness of the oxide layer 6 is reduced at a bottom edge corner 8 of the island, forming a "V" shaped groove 9. Thereafter, a polysilicon conductor 10 shown in FIG.'s 2 and 3 is formed by deposition of polycrystalline silicon followed by photolithographic definition and etching. The deposited polysilicon fills the V-shaped groove 9 so that there is a significant likelihood of breakdown conduction between the polysilicon conductor 10 and the silicon island 2 in the vicinity of the V-shaped groove 9.

The polysilicon conductor 10 is deposited, photolithographically defined and etched. Thereafter, the device is ion implanted to render the polysilicon material conductive while simultaneously forming gate-aligned source and drain diffusions in the silicon island 2, in a manner well-known in the art. A second layer of oxide 11 is then placed over the device. Contacts (not shown) are defined through the oxide layers. An aluminum conductor 12 shown in FIG.'s 2 and 4 is formed by evaporation followed by photolithographic definition and etching. Because the etching process which initially defines the edge 3 of the SOS island 2 shown in FIG. 1 is not uniform, the resulting island edge 3 is rough.

FIG. 4 clearly shows that the thickness $t_1$ of the aluminum conductor 12 deposited over the steep island edge 3 is significantly reduced with respect to the aluminum thickness $t_2$ overlying horizontal surfaces. This reduction of the thickness of the aluminum conductor 12 at the edge 3 increases the probability of discontinuities in the conductor 12. As a result, it has been found that the processing yield of metal-oxide-semi-conductor silicon-on-sapphire (MOS/SOS) devices is significantly reduced.

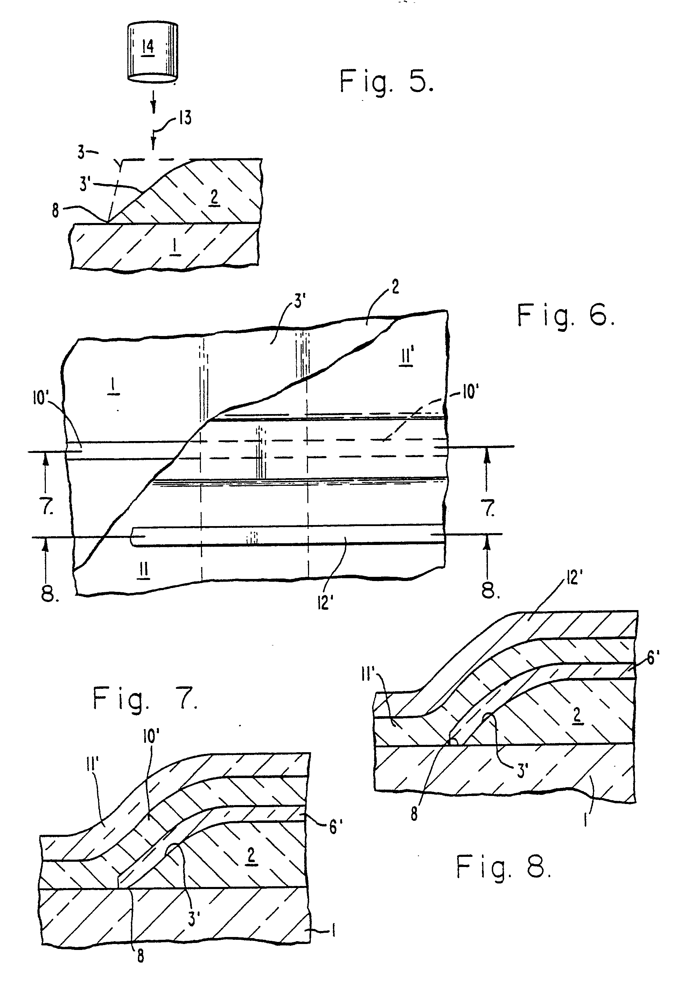

The foregoing problems are solved using the method of the present invention illustrated in FIG. 5 by directing a pulsed beam 13 of radiant energy from an energy source 14 such as a laser toward the silicon island 2 prior to the growth or deposition of overlying insulating and conductive layers. The drawing of FIG. 5 is purely schematic and does not imply any restriction on required beam size. The energy beam 13 causes reflow of silicon in the island edge 3, and the result is a reformed island edge 3' shown in solid line in FIG. 5. Furthermore, the energy beam improves the quality of the crystal structure of the silicon island 2, which increases the channel mobility of metal oxide semiconductor field effect transistors (MOSFET's) fabricated on the silicon island 2. It should be noted that, in order to increase mobility, the energy beam may be applied either before or after definition of the silicon island 2. Mobility in MOS transistors is a well-known concept in the art and is discussed, for example, in Penny et al., *MOS Integrated Circuits*, Van Nostrand, Reinhold Co., 1972, pages 162—168, the disclosure of which is incorporated by reference. Referring to FIG.'s 7 and 8, an oxide layer 6, a polysilicon conductor 10, a second oxide layer 11 and an aluminum conductor 12 are deposited in the manner described in connection with FIG.'s 1—4. The reformed island edge 3' has a moderate slope, being oriented at approximately 60° with respect to the top of the sapphire substrate 1.

Referring to FIG. 8, the moderate slope of the island edge 3' permits the deposited aluminum conduction layer 12 to assume a nearly uniform thickness along the island edge, reducing the likelihood of physical discontinuities in the aluminum conductor 12.

Referring to FIG. 7, the likelihood of breakdown conduction at the bottom edge corner 8 between the polysilicon conductor 6 and the silicon island 2 is significantly reduced because the V-shaped groove 9 is eliminated due to the reduced slope of the silicon island edge 3'.

In the preferred method of this invention, the energy beam source 14 of FIG. 5 is a pulsed excimer laser, emitting a beam 13 having a pulse duration of approximately 25 nanoseconds, a wavelength of approximately 2490 Å, and an energy density between 0.5 and 1.0 joule/cm². However, it should be recognized that the scope of this invention includes the use of any pulsed beam source or continuous scanning beam source, including an electron, ion or laser beam source in accordance with the present method. The method of this invention is applicable to any MOS/SOS structure similar to that of FIGS. 6, 7, and 8 in which the first insulating layer is any suitable dielectric, including grown silicon oxide, chemical vapor deposited silicon dioxide, grown silicon nitride, or grown silicon dioxide with chemical vapor deposited silicon nitride. The first insulating layer 6 may be grown or deposited silicon dioxide $SiO_2$ or silicon nitride ($Si_3N_4$) of the type discussed by Pliskin, "Comparison of Properties of Dielectric Films Deposited by Various Methods", *Journal of Vacuum Science Technology*, Vol. 14, No. 5, September/October 1977, pp. 1064—1081.

The first conductive layer 10 may be any polycrystalline or amorphous material, such as polycrystalline silicon or it may be polycide or metal silicide of the type disclosed in Crowder et al., "1 μm MOSFET VLSI Technology: Part VII Metal Silicide Interconnection Technology — A Future Prospective", IEEE Trans. on Electron Devices, Vol. Ed.-26, No. 4, April 1979, pages 369—371. Alternatively, the conductive layer 10 may also be a refractory metal layer of the type disclosed in Shah, "Refractory Metal Gate Processes for VLSI Applications", IEEE Trans. on Electron Devices, Vol. ED-26, No. 4, April 1979, pages 631—640. The disclosures of the above-identified Crowder, Shah and Pliskin publications are hereby expressly incorporated herein by reference in their entirety.

In summary, this invention is a unique processing technique for improving silicon on sapphire device performance causing the silicon material in the vicinity of the silicon island edge to reflow in such a way as to decrease the slope of the island edge and to increase smoothness of the island edge. Overlying aluminum conductive layers are of more uniform thickness throughout the device, even in the vicinity of the island edge, advantageously decreasing the probability of discontinuities in the aluminum layer. Finally, improvement of the SOS island edge prevents formation of a V-shape groove in the first oxide layer at the bottom island edge corner, thereby decreasing the probability of breakdown conduction between polysilicon conductors and the silicon island.

## Claims

1. A method for treating a surface region of semiconductor material (2) comprising a silicon island of predefined extent having edges which is characterised by irradiating the surface of the silicon island with a radiation beam (13) of a chosen energy per unit area sufficient to cause the silicon material in the vicinity of the edges to reflow, whereby the step geometry at the edges of the silicon island are smoothed and rounded to provide improved step coverage for layers subsequently deposited thereover.

2. A method according to claim 1 wherein the radiation beam is a continuous beam of radiation which is scanned across the surface region of semiconductor material.

3. A method according to claim 1 wherein the radiation beam is a pulsed beam of radiation.

4. A method according to claim 1 wherein the radiation beam is a laser beam.

5. A method according to claim 4 wherein the irradiating beam has a pulse duration of approximately 25 nanoseconds, a wavelength of approximately 2490 angstroms and an energy density between 0.5 and 1.0 joule per centimeter squared.

6. A method according to claim 1 wherein said radiation beam comprises an electron beam.

7. A method according to claim 1 wherein said radiation beam comprises an ion beam.

8. In a metal oxide semi-conductor silicon-on-sapphire device having a plurality of silicon islands (2), a method for improving metal step coverage by a metal layer (12) and for preventing breakdown conduction between an insulated conductive layer (10) and the silicon islands, comprising forming a plurality of silicon islands (2) on a sapphire substrate (1) to define an island edge (3) surrounding each of said silicon islands and the method being characterised by exposing said silicon islands to a beam of energy (13) of sufficient magnitude to cause the silicon material in the vicinity of said island edge to reflow (as at 3') so as to reduce the slope and smooth the surface of said edges.

## Patentansprüche

1. Verfahren zur Behandlung einer Oberflächenregion eines Halbleitermaterials (2) mit einer Siliziuminsel vorbestimmten Ausmaßes, die Kanten aufweist, gekennzeichnet durch Bestrahlen der Oberfläche der Siliziuminsel mit einem Energiestrahl (13), der eine bestimmte Energie pro Flächeneinheit aufweist, die groß genug ist, das Siliziummaterial in der Umgebung der Kanten zu schmelzen, wodurch die Stufengeometrie der Kanten der Siliziuminsel geglättet und abgerundet wird, um die Abdeckung der Stufe durch nachfolgend darauf abgelagerte Schichten zu verbessern.

2. Verfahren nach Anspruch 1, dadurch gekennzeichnet, daß der Energiestrahl ein kontinuierlicher Strahl ist, der die Oberflächenregion des Halbleitermaterials abtastet.

3. Verfahren nach Anspruch 1, dadurch gekennzeichnet, daß der Energiestrahl ein gepulster Strahl ist.

4. Verfahren nach Anspruch 1, dadurch gekennzeichnet, daß der Energiestrahl ein Laserstrahl ist.

5. Verfahren nach Anspruch 4, dadurch gekennzeichnet, daß der Energiestrahl eine Impulsdauer von ungefähr 25 Nanosekunden, eine Wellenlänge von ungefähr 2490 Angström und eine Energiedichte zwischen 0,5 und 1,0 Joule pro Quadratzentimeter aufweist.

6. Verfahren nach Anspruch 1, dadurch gekennzeichnet, daß der Energiestrahl einen Elektronenstrahl umfaßt.

7. Verfahren nach Anspruch 1, dadurch gekennzeichnet, daß der Energiestrahl einen Ionenstrahl umfaßt.

8. In einer Metalloxidhalbleiter-Silizium-Anordnung mit einer Mehrzahl von Siliziuminseln (2), ein Verfahren zum Verbessern der metallischen Stufenabdeckung durch eine metallische Schicht (12) und zum Verhindern der Durchbruchleitung zwischen einer isolierten Leiterschicht (10) und den Siliziuminseln, wobei eine Mehrzahl von Siliziuminseln (2) auf einem Saphirsubstrat (1) ausgebildet werden, um die die Siliziuminseln umgrenzenden Inselkanten (3) festzulegen, dadurch gekennzeichnet, daß die Siliziuminseln einem Energiestrahl (13) ausgesetzt werden, dessen Stärke groß genug ist, um das Siliziummaterial in der Umgebung der Inselkanten zum Zerfließen zu bringen (wie bei 3'), um die Steigung der Kanten zu verkleinern und die Oberfläche der Kanten zu glätten.

**Revendications**

1. Procédé pour traiter une région de la surface d'un matériau semi-conducteur (2) comportant un îlot de silicium de dimension prédéterminée ayant des bords, caractérisé en ce que l'on irradie la surface de l'îlot de silicium avec un faisceau de radiation (13) ayant une énergie par surface unitaire choisie suffisante pour provoquer la fusion du matériau silicium à proximité des bords, de façon à atténuer et arrondir la géométrie du gradin aux bords de l'îlot de silicium, pour assurer une couverture améliorée du gradin pour les couches qui seront ultérieurement déposées sur celui-ci.

2. Procédé selon la revendication 1, dans lequel le faisceau de radiation est un faisceau de radiation continu qui balaie la région de la surface du matériau semi-conducteur.

3. Procédé selon la revendication 1, dans lequel le faisceau de radiation est un faisceau de radiation à impulsions.

4. Procédé selon la revendication 1, dans lequel le faisceau de radiation est un faisceau laser.

5. Procédé selon la revendication 4, dans lequel le faisceau d'irradiation a une durée d'impulsion d'environ 25 nanosecondes, une longueur d'onde d'environ 2490 Angströms et une densité d'énergie entre 0,5 et 1,0 joule par centimètre carré.

6. Procédé selon la revendication 1, dans lequel le faisceau de radiation comprend un faisceau d'électrons.

7. Procédé selon la revendication 1, dans lequel le faisceau de radiation comprend un faisceau d'ions.

8. Dans un dispositif semi-conducteur métal-oxyde silicium sur saphir comportant plusieurs îlots de silicium (2), procédé pour améliorer la couverture métallique de gradin par une couche de métal (12) et pour éviter la conduction par claquage entre une couche conductrice isolée (10) et les îlots de silicium, comprenant l'étape consistant à former plusieurs îlots de silicium (2) sur un substrat de saphir (1) pour définir un bord (3) d'îlot entourant chacun des îlots de silicium, ce procédé étant caractérisé en ce que l'on expose les îlots de silicium à un faisceau d'énergie (13) d'une valeur suffisante pour provoquer la fusion du matériau silicium à proximité du bord de l'îlot (comme en 3') de manière à réduire la pente et adoucir la surface des bords.

Fig. 1.

Fig. 2.

Fig. 3.

Fig. 4.

Fig. 5.

Fig. 6.

Fig. 7.

Fig. 8.